# EUROPEAN PATENT APPLICATION

(11) **EP 2 275 243 A1**
(43) Date of publication of application: **19.01.2011**
(21) Application number: 10004518.6
(22) Date of filing: 29.04.2010
(51) Int. Cl.: B29C 45/14, B44C 1/14, E05B 17/22, E05B 7/00, H03K 17/96, E05B 65/20

(54) **Metallic resin cover and method of producing the same, and door handle for vehicle**

(30) Priority: 14.07.2009 JP 2009165359; 22.12.2009 JP 2009290051
(71) Applicant: Pacific Industrial Co., Ltd., Ogaki-shi, Gifu-ken 503-8603 (JP)
(72) Inventor: Ueno, Kazushige, Ogaki-shi, Gifu-ken 503-8603 (JP); Ota, Satoshi, Ogaki-shi, Gifu-ken 503-8603 (JP)
(74) Representative: Kuhnen & Wacker

(57) **Abstract**

A metallic resin cover (55) constitutes a portion of an outer wall of a human detection device (50) in which a detection electrode (53D) of a capacitance sensor (53) is provided, and which detects whether a human touches or approaches the human detection device (50). The metallic resin cover (55) includes a covered body (57); and a metal layer (13) that has a metal-object discretely arranged structure in which a plurality of metal objects (13A) are discretely arranged, wherein the metal layer (13) covers an outer surface of the covered body (57).

## Description

### BACKGROUND OF THE INVENTION

### 1. Field of the Invention

The invention relates to a metallic resin cover used to decorate a human detection device in which a detection electrode of a capacitance sensor is provided, and which detects whether a human touches or approaches the human detection device, and a method of producing the metallic resin cover, and a door handle for a vehicle.

### 2. Description of the Related Art

A door handle for a vehicle and a door phone for home are known examples of a human detection device in which a detection electrode of a capacitance sensor is provided. For example, when the door handle for a vehicle detects that a driver or a passenger touches the door handle using the capacitance sensor, a door is automatically unlocked. The door phone detects whether a human touches the door phone using the capacitance sensor (for example, refer to Japanese Patent Application Publication No. 2003-221946 (JP-A-2003-221946), and Japanese Patent Application Publication No. 2006-287467 (JP-A-2006-287467)).

Because the human detection device is disposed at such a position that the human detection device is visible to people, high-quality design of the human detection device is required. Therefore, metallic decoration may be provided in a portion of the human detection device. In this case, conventionally, a portion of the human detection device is covered with metal plating, or a portion of an outer wall of the human detection device is covered with a sheet-formed component that is formed of a metallic forming sheet including a metal layer.

However, in the conventional human detection device that is partly covered with, for example, plating or the metallic forming sheet, there is a possibility that the capacitance sensor may malfunction, and it may become impossible to detect whether, for example, a human touches the human detection device. Therefore, the metallic decorative surface needs to be made small.

### SUMMARY OF THE INVENTION

The invention provides a metallic resign cover that makes a metallic decorative surface larger than a conventional metallic decorative surface, without decreasing a detection function of a capacitance sensor, a method of producing the same, and a door handle for a vehicle.

A first aspect of the invention relates to a metallic resin cover that constitutes a portion of an outer wall of a human detection device in which a detection electrode of a capacitance sensor is provided, and which detects whether a human touches or approaches the human detection device. The metallic resin cover includes a covered body; and a metal layer that has a metal-object discretely arranged structure in which a plurality of metal objects are discretely arranged, wherein the metal layer covers an outer surface of the covered body.

According to the first aspect, the entire metal layer is not one continuous conductive layer. Thus, when the decoration is provided in a portion of the human detection device using the metallic resin cover in which the metal layer covers the outer surface of the covered body, it is possible to suppress an adverse effect on the capacitance sensor, as compared to when conventional plating or a conventional metallic forming sheet is used. Thus, it is possible to make the metallic decorative surface larger than a conventional metallic decorative surface, without decreasing the detection function of the capacitance sensor.

In the first aspect, an average thickness of the metal layer may be 10 to 70 nm; an average diameter of the metal objects may be 30 to 150 nm when the metal layer is seen in a direction of thickness of the metal layer; and an average gap between the metal objects may be 5 to 30 nm.

In the above-described aspect, the metal layer may be a metal vapor-deposited layer. The metal layer may be a layer formed by vappr-deposition of indium.

When the metal layer is configured so that the average thickness of the metal layer, the average diameter of the plurality of metal objects, and the average gap between the metal objects are set to the values in the above-described aspect, the entire metal layer looks like one metal component. Also, the metal layer thus configured is easily formed by vapor-depositing indium.

The metallic resin cover according to the above-described aspect may further include paired resin layers between which the metal layer is provided. A sheet-formed component may be formed of a metallic forming sheet including the paired resin layers and the metal layer provided between the paired resin layers; and the covered body may be an insert-molded component formed by insert molding using the sheet-formed component.

According to the above-described aspect, the metallic resin cover is easily mass-produced, as compared to a cover in which the metal layer is, for example, vapor-deposited on the outer surface of the covered body.

In the above-described aspect, the sheet-formed component may have a groove shape or a container shape; a side wall of the sheet-formed component may be curved to bulge outward; the covered body may include a stepped surface that is joined to a distal end surface of the side wall of the sheet-formed component.

In general, in a sheet with a multi-layer structure, such as the metallic forming sheet, layers are separated from each other, when the stacked layers of the metallic forming sheet are curved and deformed in a manner such that the layers are curled from exposed end surfaces thereof. However, according to the above-described aspect, because the distal end surface of the side wall of the sheet-formed component is covered with the covered body, the layers are prevented from being separated from each other. Further, because the side wall of the sheet-formed component is curved to bulge outward, the side wall is prevented from being curved and deformed to bulge in a direction opposite to the direction in which the side wall bulges. This also prevents the layers of the sheet-formed component from being separated from each other.

A second aspect of the invention relates to an automatic locking system that includes the metallic resin cover in the first described aspect. The human detection device provided with the metallic resin cover is a door handle for a vehicle, which is fixed to an outer wall of a door of the vehicle; and when the capacitance sensor in the door handle detects that a human touches or approaches the door handle, the door is automatically unlocked or locked.

According to the second aspect, the metallic decoration is provided in a portion of the door handle for the vehicle, without decreasing the function of the automatic locking system using the door handle for the vehicle.

When a portion of the door handle for the vehicle is decorated using conventional plating or a conventional metallic forming sheet, placement of the detection electrode of the capacitance sensor in the inner area of the door handle is greatly restricted to suppress an adverse effect on the capacitance sensor. In contrast, according to the above-described aspect, it is possible to suppress an adverse effect on the capacitance sensor as compared to when the conventional plating or the conventional metallic forming sheet is used. Therefore, it is possible to increase flexibility in placement of the detection electrode in the inner area of the door handle.

A third aspect of the invention relates to a method of producing a metallic resin cover. The method includes forming a sheet-formed component using a metallic forming sheet, wherein in the metallic forming sheet, a metal layer is provided between paired first and second resin layers, and the metal layer has a metal-object discretely arranged structure in which a plurality of metal objects are discretely arranged; forming a covered body using a molding die in which the sheet-formed component is inserted; and covering an outer surface of the covered body with the sheet-formed component, wherein the covered body constitutes a portion of an outer wall of a human detection device in which a detection electrode of a capacitance sensor is provided, and which detects whether a human touches or approaches the human detection device.

According to the third aspect, the entire metal layer is not one continuous conductive layer. Thus, when the decoration is provided in a portion of the human detection device using the metallic resin cover in which the metal layer covers the outer surface of the covered body, it is possible to suppress an adverse effect on the capacitance sensor, as compared to when conventional plating or a conventional metallic forming sheet is used. Thus, it is possible to make the metallic decorative surface larger than a conventional metallic decorative surface, without decreasing the detection function of the capacitance sensor. Also, the metallic resin cover is easily mass-produced, as compared to a cover in which the metal layer is, for example, vapor-deposited on the outer surface of the covered body.

In the third aspect, an average thickness of the metal layer may be 10 to 70 nm; an average diameter of the plurality of metal objects may be 30 to 150 nm when the metal layer is seen in a direction of thickness of the metal layer; and an average gap between the metal objects may be 5 to 30 nm.

In the above-described aspect, the metallic forming sheet may be formed by forming the metal layer by vapor-depositing indium on a resin film that is a first resin layer, and fixing a base resin film that is a second resin layer, to a surface of the metal layer that is opposite to a surface of the metal layer that faces the first resin layer, with an adhesive layer provided between the second resin layer and the metal layer.

In the above-described aspect, a portion of the metallic forming sheet may be formed into the sheet-formed component, and the sheet-formed component may be separated from the entire metallic forming sheet by laser cutting.

According to the above-described aspect, it is possible to suppress generation of shearing force in the cut surface formed by, for example, press-cutting. Thus, it is possible to prevent the layers of the sheet-formed component from being separated from each other at the cut surface.

In the above-described aspect, the sheet-formed component may have a groove shape or a container shape, and a side wall of the sheet-formed component may be curved to bulge outward; and a distal end surface of the side wall may be covered with the covered body.

In the above-described aspect, the covered body may be formed while a parting line of the molding die, in which the sheet-formed component is inserted, is disposed at a position between a proximal end and a distal end of a side wall of the sheet-formed component.

According to the above-described aspect, the parting line is offset from the distal end surface of the side wall of the sheet-formed component. This increases the degree of adhesion between the distal end surface of the side wall of the sheet-formed component and the covered body. Thus, it is possible to prevent the sheet-formed component from being separated from the covered body, in addition to preventing the layers of the sheet-formed component from being separated from each other.

A fourth aspect of the invention relates to a door handle for a vehicle, which is fixed to an outer wall of a door of a vehicle, and which is used in an automatic locking system in which when it is detected that a human touches or approaches the door handle, the door is automatically unlocked or locked. The door handle includes the metallic resin cover according to the first aspect; and the detection electrode of the capacitance sensor, which detects whether the human touches or approaches the door handle. The metallic resin cover constitutes an outer surface of the door handle that is opposite to a surface of the door handle that faces the door; and the detection electrode is in contact with a reverse side of the metallic resin cover, or the detection electrode is disposed in a vicinity of the reverse side of the metallic resin cover.

A fifth aspect of the invention relates to a door handle for a vehicle, which is fixed to an outer wall of a door of a vehicle, and which is used in an automatic locking system in which when it is detected that a human touches or approaches the door handle, the door is automatically unlocked or locked. The door handle includes the metallic resin cover according to the first aspect; and the detection electrode of the capacitance sensor, which detects whether the human touches or approaches the door handle. The metallic resin cover constitutes an outer surface of the door handle that is opposite to a surface of the door handle that faces the door; and the detection electrode is disposed in a center portion of an inner area of the door handle in a direction perpendicular to a longitudinal direction of the door handle.

A sixth aspect of the invention relates to a door handle for a vehicle, which is fixed to an outer wall of a door of a vehicle so that the door handle extends in a longitudinal direction of the vehicle, and which is used in an automatic locking system in which when it is detected that a human touches or approaches the door handle, the door is automatically unlocked or locked. The door handle includes the metallic resin cover according to the first aspect; and the detection electrode of the capacitance sensor, which detects whether the human touches or approaches the door handle. The metallic resin cover constitutes an outer surface of the door handle that is opposite to a surface of the door handle that faces the door; and the detection electrode is disposed in an inner area of the door handle at a position closer to an upper side surface of the door handle than to a lower side surface of the door handle.

A seventh aspect of the invention relates to a door handle for a vehicle, which is fixed to an outer wall of a door of a vehicle so that the door handle extends in a longitudinal direction of the vehicle, and which is used in an automatic locking system in which when it is detected that a human touches or approaches the door handle, the door is automatically unlocked or locked. The door handle includes the metallic resin cover according to the first aspect; and the detection electrode of the capacitance sensor, which detects whether the human touches or approaches the door handle. The metallic resin cover constitutes an outer surface of the door handle that is opposite to a surface of the door handle that faces the door; and the detection electrode is disposed in an inner area of the door handle at a position closer to a lower side surface of the door handle than to an upper side surface of the door handle.

When a portion of the outer surface of the door handle is decorated using the conventional plating or the conventional metallic forming sheet, the detection electrode of the capacitance sensor needs to be disposed at a distance equal to or larger than a certain distance from a decorative surface of the door handle, in order to suppress an adverse effect on the capacitance sensor. For example, when the outer surface of the door handle, which is opposite to a surface of the door handle that faces the door, is a decorative surface decorated using the conventional plating or the conventional metallic forming sheet, the detection electrode can be disposed in the inner area of the door handle only at a position closer to the surface that faces the door than to the decorative surface.

In contrast, according to the fourth to seventh aspects, it is possible to dispose the detection electrode of the capacitance sensor even at positions at which it is conventionally difficult to dispose the detection electrode, that is, positions at which an adverse effect on the capacitance sensor is caused when the conventional plating or the conventional metallic forming sheet is used. Thus, it is possible to increase flexibility in placement of the detection electrode.

For example, according to the fourth aspect, it is possible to reduce the thickness of the door handle in the direction facing the door.

According to the fifth aspect, it is possible to concentrate components of the capacitance sensor including the detection electrode in the center portion of the inner area of the door handle in the direction perpendicular to the longitudinal direction of the door handle.

Also, according to the sixth aspect, it is possible to quickly detect that a human touches or approaches the door handle when the human is going to grasp the door handle with the back of a hand facing upward.

Further, according to the seventh aspect, it is possible to quickly detect that a human touches or approaches the door handle when the human is going to grasp the door handle with the back of the hand facing downward.

In the door handle according to any one of the fourth to seventh aspects, the door handle is substantially arched in a longitudinal direction thereof, and only an intermediate portion of the door handle in the longitudinal direction thereof is grasped; the metallic resin cover has a band shape that extends over the entire door handle in the longitudinal direction of the door handle, and the metallic resin cover is arched; the detection electrode of the capacitance sensor used for unlocking the door is disposed in the intermediate portion of the door handle in the longitudinal direction thereof; and the detection electrode of the capacitance sensor used for locking the door is disposed at a position between the intermediate portion and an end of the door handle in the longitudinal direction thereof

According to the above-described aspect, it is possible to improve decorativeness as compared to when metallic decoration is provided in only a portion of the door handle in the longitudinal direction thereof. When the metallic resin cover is used, it is possible to suppress an adverse effect on the capacitance sensor as compared to when the conventional plating or the conventional metallic forming sheet is used. Therefore, it is possible to dispose the detection electrode of the capacitance sensor used for unlocking the door at the intermediate portion of the door handle in the longitudinal direction thereof, and to dispose the detection electrode of the capacitance sensor used for locking the door at the position between the intermediate portion and the end of the door handle in the longitudinal direction thereof. That is, it is possible to make it easier to lock and unlock the door of the vehicle, while improving the decorativeness of the door handle.

### BRIEF DESCRIPTION OF THE DRAWINGS

The features, advantages, and technical and industrial significance of this inveniton will be described in the following detailed description of example embodiments of the invention with reference to the accompanying drawings, in which like numerals denote like elemtns, and wherein:
FIG. 1 is a perspective view of a door handle according to a first embodiment of the invention;
FIG. 2 is an exploded perspective view of the door handle shown in FIG. 1;
FIG. 3 is a side sectional view of the door handle shown in FIG. 1;
FIG. 4 is a sectional view of a metallic resin cover taken along a line IV - IV in FIG 2;
FIG. 5 is a side sectional view of a metallic forming sheet according to the first embodiment of the invention;
FIG. 6 is a side sectional view of the metallic forming sheet and a vacuum forming die according to the first embodiment of the invention;
FIG. 7 is a sectional view of the metallic forming sheet in a trimming process according to the first embodiment of the invention;
FIG. 8 is a sectional view of a sheet-formed component and an injection molding die according to the first embodiment of the invention;
FIG. 9 is a sectional view showing a situation in which the sheet-formed component is inserted in the injection molding die according to the first embodiment of the invention;
FIG. 10 is a plane view of a metal layer of the metallic forming sheet according to the first embodiment of the invention;
FIG. 11 is a side sectional view of the metal layer of the metallic forming sheet according to the first embodiment of the invention;
FIGS. 12A and 12B are sectional views of the sheet-formed component cut out by laser according to the first embodiment of the invention;
FIG. 13 is a sectional view of a trimmed surface of the sheet-formed component, which is formed by laser cutting according to the first embodiment of the invention;
FIGS. 14A and 14B are sectional views of the sheet-formed component cut out by a press machine;
FIG. 15 is a sectional view of a door handle according to a second embodiment of the invention taken at an intermediate position of the door handle in a longitudinal direction thereof;
FIG. 16 is a sectional view of a door handle according to a third embodiment of the invention taken at an intermediate position of the door handle in a longitudinal direction thereof;
FIG. 17 is a sectional view of a door handle according to a fourth embodiment of the invention taken at an intermediate position of the door handle in a longitudinal direction thereof;
FIG. 18 is a sectional view of a door handle according to a fifth embodiment of the invention taken at an intermediate position of the door handle in a longitudinal direction thereof; and
FIG. 19 is a perspective view of a door handle according to a modified example.

### DETAILED DESCRIPTION OF EMBODIMENTS

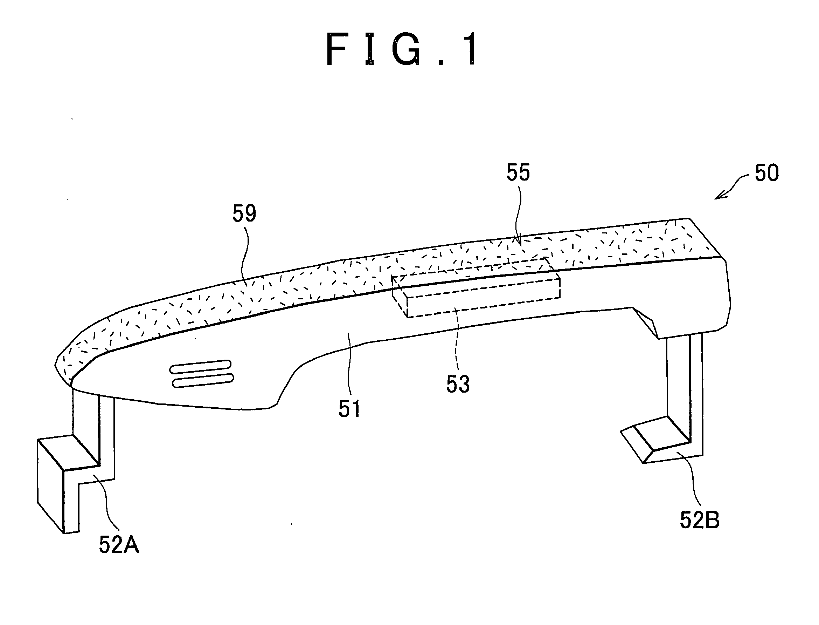

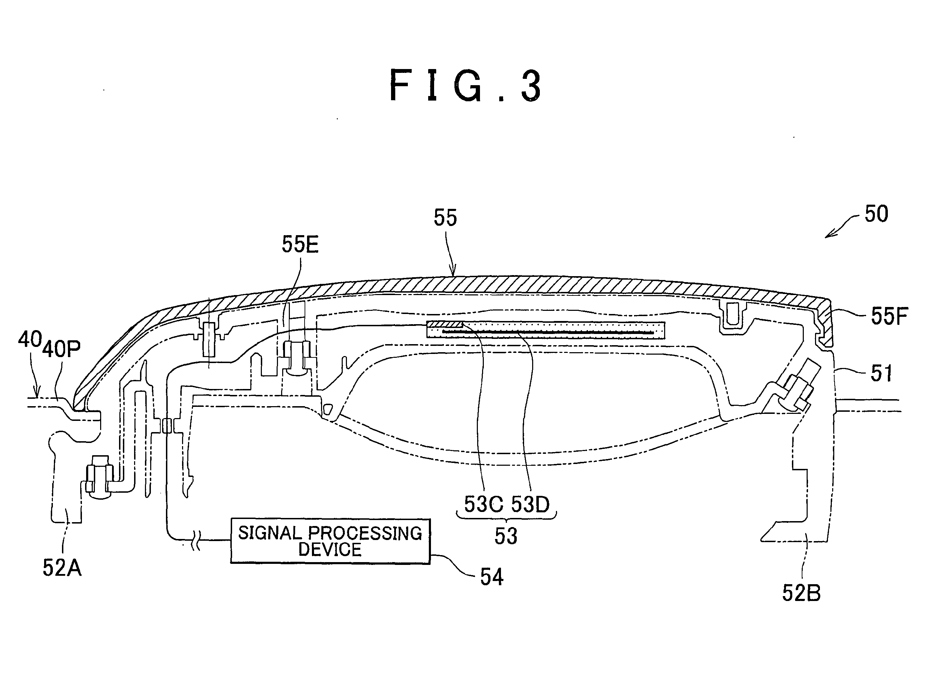

Hereinafter, a first embodiment of the invention will be described with reference to FIG. 1 to FIG. 14. FIG. 1 shows a door handle 50 for a vehicle (hereinafter, simply referred to as "door handle 50"), which is an example of a human detection device according to the invention. The door handle 50 is substantially arched in a longitudinal direction thereof. Paired fixation legs 52A and 52B protrude from respective end portions of the door handle 50 in the longitudinal direction thereof. The paired fixation legs 52A and 52B are fixed in a manner such that the paired fixation legs 52A and 52B are inserted into through holes formed in an outer surface panel 40P of a door 40 (refer to FIG. 3).

As shown in FIG. 3, a capacitance sensor 53 is provided in the door handle 50. For example, the capacitance sensor 53 is formed by packaging a detection electrode 53D and a capacitance detection circuit 53C using resin. The detection electrode 53D is a band plate that extends in the longitudinal direction of the door handle 50. The capacitance detection circuit 53C detects a change in the capacitance of the capacitance sensor 53. The capacitance sensor 53 is disposed in an intermediate portion of the door handle 50 in the longitudinal direction of the door handle 50. In an inner area of the door handle 50, the capacitance sensor 53 is disposed at a position closer to the door 40 than a center of the door handle 50 in a direction perpendicular to the longitudinal direction of the door handle 50 is when the door handle 50 is fixed to the door 40. When a human finger touches a surface of the handle 50 that faces the door 40 (hereinafter, the surface will be referred to as "door-40 facing surface"), the capacitance of the detection electrode 53D changes to exceed a predetermined reference value. The change in the capacitance of the detection electrode 53D is detected by the capacitance detection circuit 53C, and thus; it is detected that a human touches the door handle 50.

When the capacitance sensor 53 detects that a human touches the door handle 50, for example, a signal processing device 54 provided in a vehicle wirelessly determines whether there is a predetermined Radio Frequency Identification (RFID) nearby. If there is the predetermined RFID nearby, the door 40 is unlocked, and a latch mechanism (not shown) is disengaged from the door 40. This enables a driver or a passenger to enter the vehicle.

As shown in FIG. 1, a portion of an outer surface of the door handle 50 is a metallic decorative surface 59 that is formed to improve design quality. The metallic decorative surface 59 is located opposite to the door-40 facing surface of the door handle 50. The metallic decorative surface 59 has a band shape that extends over the entire door handle 50 in the longitudinal direction of the door handle 50. A portion of an outer wall of the door handle 50 is constituted by a metallic resin cover 55 to provide the metallic decorative surface 59.

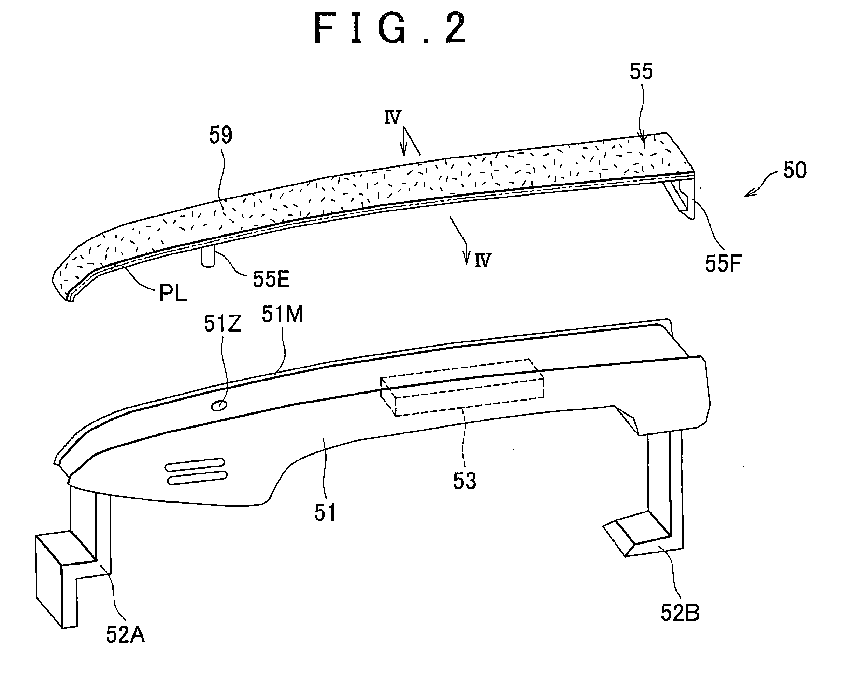

As shown in FIG. 2, the entire metallic resin cover 55 is arched in a longitudinal direction thereof. The curvature of the metallic resin cover 55 is large at a first end portion. When the door handle 50 is fixed to the door 40, a first end surface of the metallic resin cover 55 contacts the outer surface of the door 40 (refer to FIG. 3). A fixation piece 55F, which has a hooked end, protrudes from a second end portion of the metallic resin cover 55 toward the door 40. Further, a cylindrical portion 55E protrudes from the metallic resin cover 55 toward the door 40. The cylindrical portion 55E is located at a position closer to the first end portion than a center of the metallic resin cover 55 is. The cylindrical portion 55E is used when the metallic resin cover 55 is fixed using a screw.

An outer surface groove 51M is formed in a handle body 51 that is a portion of the door handle 50 other than the metallic resin cover 55. The outer surface groove 51M is located on a surface of the handle body 51 that is opposite to the door-40 facing surface. The metallic resin cover 55 is fitted in the outer surface groove 51M. The outer surface groove 51M continuously extends onto the second end surface of the door handle 50 in the longitudinal direction. Thus, the fixation piece 55F is fitted in a portion of the outer surface groove 51M, which is located on the second end surface. Further, a bottom surface hole 51Z is formed in a bottom surface of the outer surface groove 51M. The cylindrical portion 55E of the metallic resin cover 55 is inserted into the bottom surface hole 51Z.

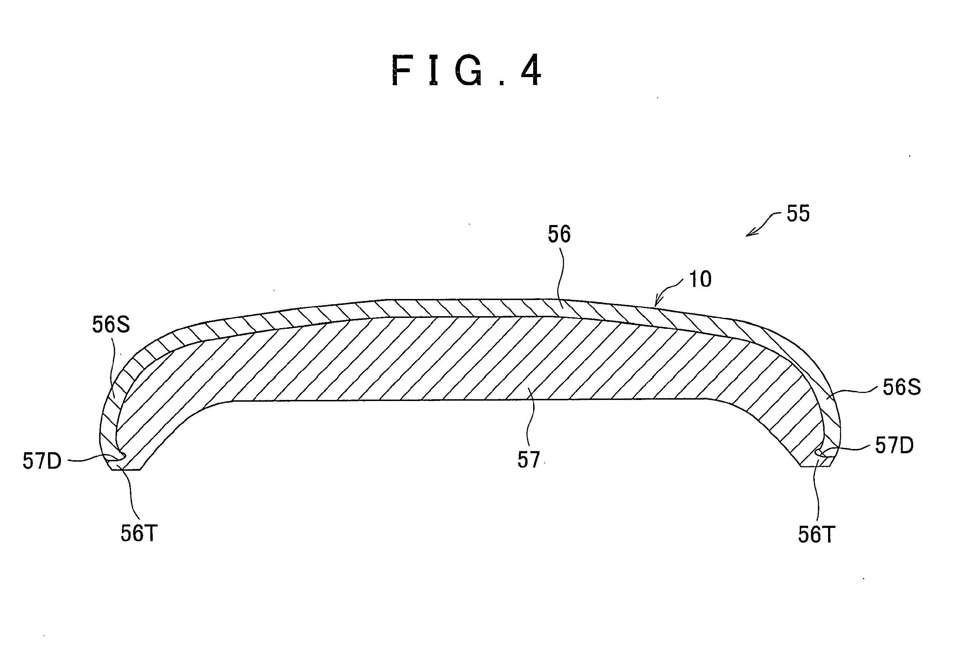

FIG. 4 is a sectional view of the metallic resin cover 55 taken at an intermediate position in the longitudinal direction. As shown in FIG. 4, the metallic resin cover 55 includes a sheet-formed component 56 and a covered body 57. A portion of the metallic resin cover 55 other than the sheet-formed component 56 is the covered body 57 formed by insert molding using the sheet-formed component 56. In the metallic resin cover 55, a surface (outer surface) of the covered body 57, which is opposite to a surface of the covered body 57 fitted to the handle body 51, is covered with the sheet-formed component 56. Both side surfaces of the covered body 57 are also covered with the sheet-formed component 56. The sheet-formed component 56 is formed of a metallic forming sheet 10 by vacuum forming. The sheet-formed component 56 has a groove shape to cover the outer surface and both side surfaces of the covered body 57. Both side walls 56S of the sheet-formed component 56 with the groove shape are curved to bulge outward. A distal end of the side wall 56S slightly overhangs with respect to a proximal end of the side wall 56S in a direction of depth of the groove (i.e., a vertical direction in FIG. 4). The fixation piece 55F of the metallic resin cover 55 is not covered with the sheet-formed component 56.

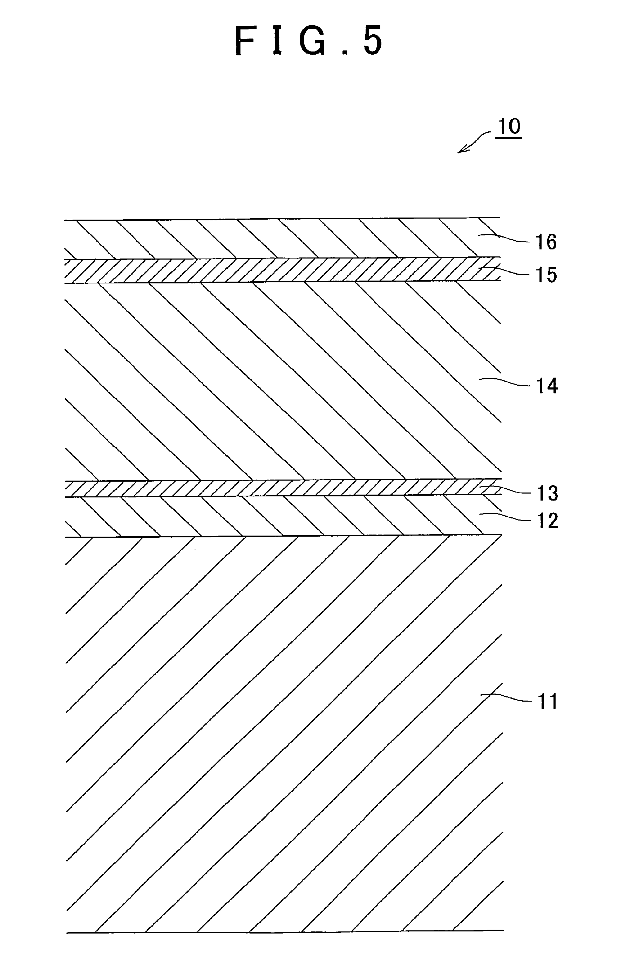

The sheet-formed component 56 is formed of the metallic forming sheet 10. As shown in FIG. 5, in the metallic forming sheet 10, a thermoplastic resin layer 11, a first adhesive layer 12, a metal layer 13, a transparent thermoplastic resin layer 14, a second adhesive layer 15, and a weather-resistant resin layer 16 are stacked in the stated order.

The thermoplastic resin layer 11 is constituted by, for example, a film made of acrylonitrile-butadiene-styrene resin (ABS). The thickness of the thermoplastic resin layer 11 is, for example, 250 µm. The first adhesive layer 12 is formed by applying a urethane adhesive agent or an acrylic adhesive agent on the entire surface of the thermoplastic resin layer 11 so that the thickness of the first adhesive layer 12 is, for example, 5 µm.

The thermoplastic resin layer 11 may be appropriately made of thermoplastic resin other than ABS. For example, the thermoplastic resin layer 11 may be made of polyvinyl chloride resin, polyolefin resin, polystyrene resin, acrylic resin, polyurethane resin, polyamide resin, or polycarbonate resin.

The transparent thermoplastic resin layer 14 is constituted by, for example, a film made of polyethylene terephthalate (PET). The thickness of the transparent thermoplastic resin layer 14 is, for example, 25 µm. The stress value of the PET film at a 100% elongation point (hereinafter, referred to as "F-100 value") is less than 100 MPa in a tensile test conducted at ordinary temperature. By using the PET film whose F-100 value is less than 100 MPa, it is possible to elongate the PET film by a relatively large amount. This increases flexibility in determining the shape into which the metallic forming sheet 10 is formed, reduces residual stress after the metallic forming sheet 10 is shaped, and prevents the layers of the metallic forming sheet 10 from separating each other after the metallic forming sheet 10 is shaped.

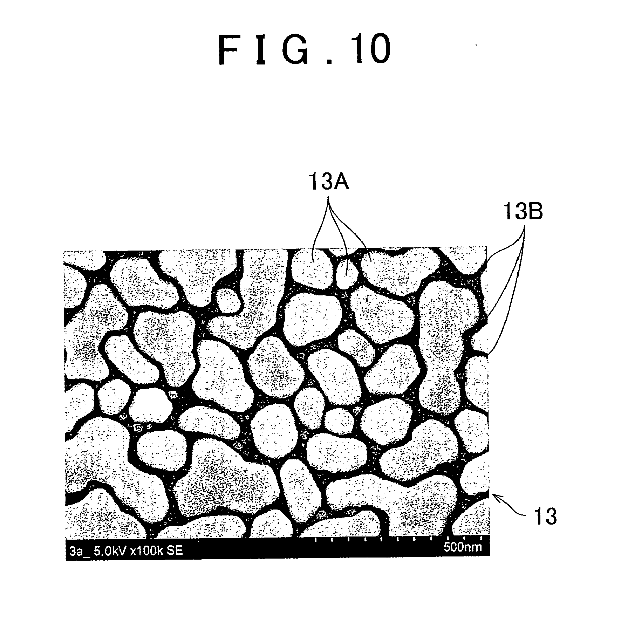

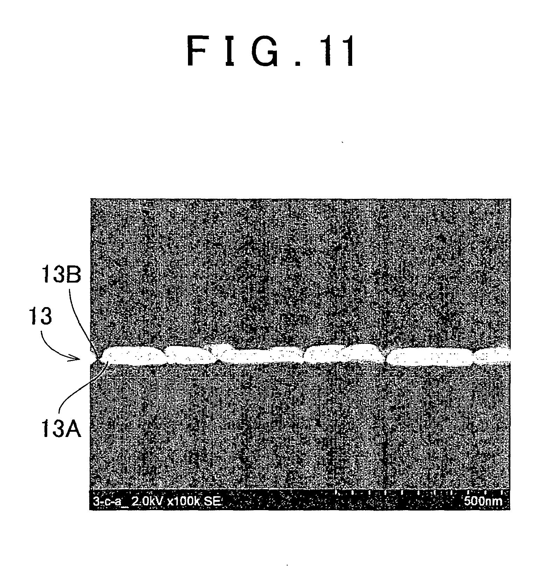

The metal layer 13 is formed by; for example, vapor-depositing indium on a surface or a reverse surface of the transparent thermoplastic resin layer 14. As shown in FIG. 10, the metal layer 13 has a metal-object discretely arranged structure in which a plurality of metal objects 13A are discretely arranged so that the metal objects 13A are away from each other with gaps 13B formed between the metal objects 13A. More specifically, the average thickness of the metal layer 13 is 60 nm (refer to FIG. 11), and the average diameter of the metal objects is 30 to 150 nm, and the average gap between the metal objects is 5 to 30 nm. A surface of the metal layer 13, which is opposite to a surface of the metal layer 13 that faces the transparent thermoplastic resins layer 14, is in close contact with the above-described first adhesive layer 12.

The second adhesive layer 15, which is similar to the first adhesive layer 12, is formed on a surface of the thermoplastic resin layer 14 that is opposite to a surface of the thermoplastic resin layer 14 that faces the metal layer 13. The weather-resistant resin layer 16 is in close contact with the second adhesive layer 15. The weather-resistant resin layer 16 is an acrylic film with the thickness of 75 µm. Thus, the metallic forming sheet 10 has a so-called laminated structure in which the metal layer 13 is provided between the thermoplastic resin layer 11, and the thermoplastic resin layer 14 and the weather-resistant resin layer 16.

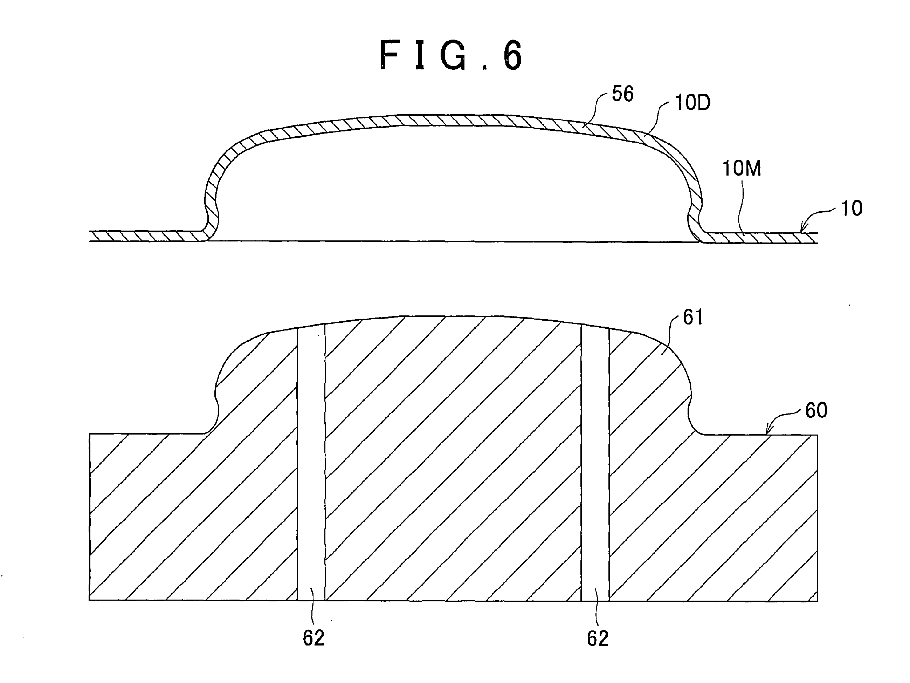

Next, a process, in which the sheet-formed component 56 is formed using the metallic forming sheet 10, will be described. First, the metallic forming sheet 10 is held by a clamp (not shown), and both sides of the metallic forming sheet 10 are heated by a heater (not shown) to soften the metallic forming sheet 10. Then, the metallic forming sheet 10 is placed on an upper surface of a vacuum forming die 60. The vacuum forming die 60 has a forming protrusion 61 that is in accordance with the shape of an inner surface of the sheet-formed component 56, as shown in FIG. 6. At this time, the thermoplastic resin layer 11 of the metallic forming sheet 10 (refer to FIG. 5) contacts the vacuum forming die 60.

Next, air between the metallic forming sheet 10 and the vacuum forming die 60 is sucked through a suction hole 62 of the vacuum forming die 60 so that the metallic forming sheet 10 is brought into close contact with an upper surface of the vacuum forming die 60. Then, the vacuum forming die 60 is cooled. After the metallic forming sheet 10 is hardened to an extent that the shape of the metallic forming sheet 10 is maintained, the metallic forming sheet 10 is taken out from the vacuum forming die 60. A side surface of the forming protrusion 61 has a so-called undercut shape in accordance with the shape of the inner surface of the sheet-formed component 56. That is, an upper portion of the side surface of the forming protrusion 61 laterally projects as compared to a lower end portion of the side surface of the forming protrusion 61. The metallic forming sheet 10 is separated from the vacuum forming die 60 while the metallic forming sheet 10 is elastically deformed. Thus, the metallic forming sheet 10 is formed into a shape in which a dome portion 10D bulges from a flat portion 10M. The dome portion 10D corresponds to the sheet-formed component 56.

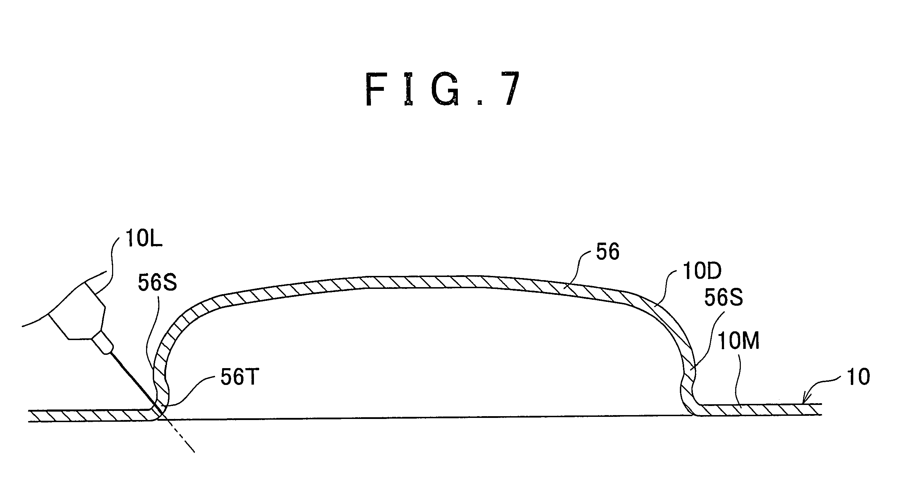

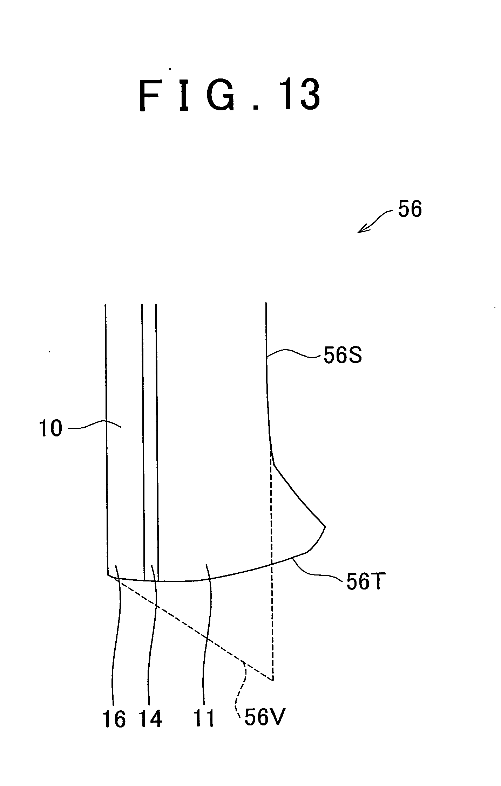

Next, as shown in FIG. 7, trimming is performed to separate the sheet-formed component 56 from the entire metallic forming sheet 10 using a laser gun 10L (for example, a carbon dioxide laser gun). More specifically, an optical axis of the laser gun 10L is inclined toward the dome portion 10D by substantially 45 degrees with respect to the flat portion 10M, and a border portion between the dome portion 10D and the flat portion 10M is cut by laser. When the sheet-formed component 56 is separated from the metallic forming sheet 10, the process of forming the sheet-formed component 56 is completed. An end surface of the side wall 56S of the sheet-formed component 56 is formed by laser cutting. If the border portion were cut by laser along the track of the optical axis of the laser gun 10L, the end surface of the side wall 56S of the sheet-formed component 56 would be inclined with respect to a direction of thickness of the metallic forming sheet 10 by approximately 45 degrees as shown by a reference numeral 56V in FIG. 13. As a result, an end of the thermoplastic resin layer 11 of the metallic forming sheet 10 would be sharply angled. However, in actuality, mainly the thermoplastic resin layer 11 is melted in the metallic forming sheet 10, and therefore, the end surface of the side wall 56S is in substantially parallel with the direction of thickness of the metallic forming sheet 10 as shown by a reference numeral 56T in FIG. 13.

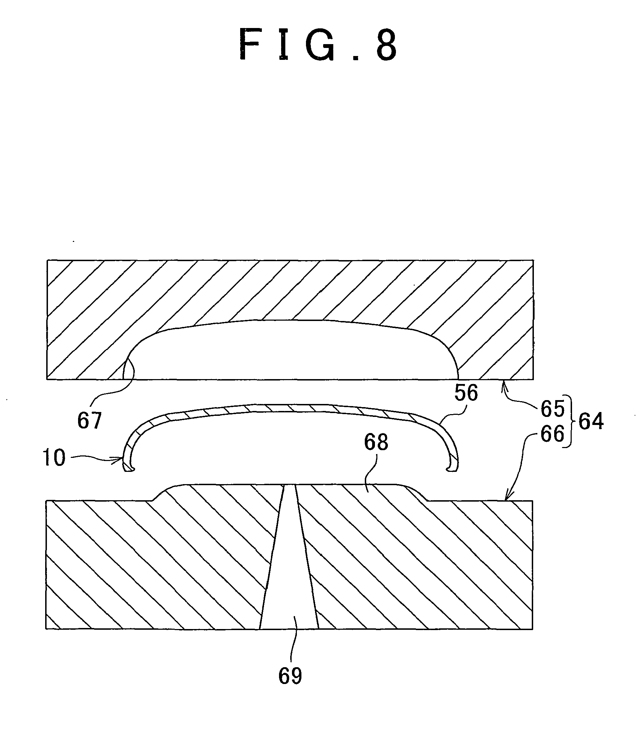

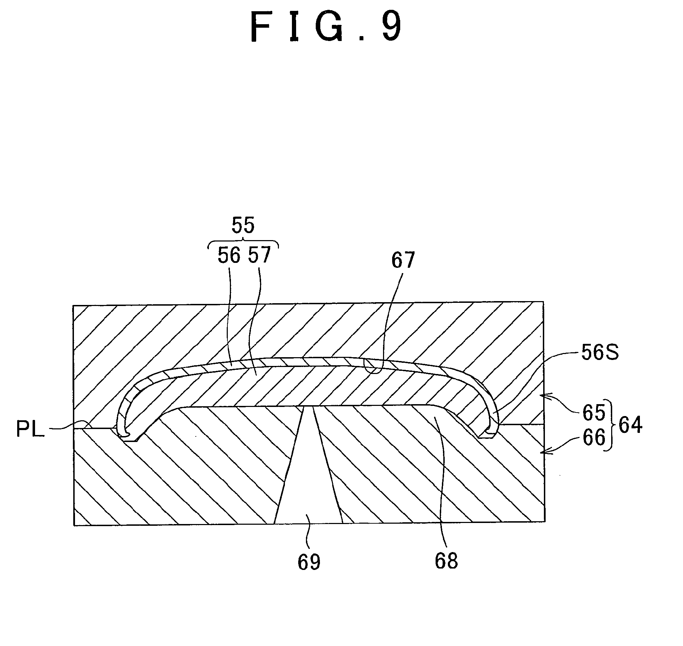

Next, a process of forming the covered body 57 will be described. The sheet-formed component 56 is inserted in an injection molding die 64 shown in FIG. 8. The injection molding die 64 includes a female die 65 and a male die 66. A recessed portion 67 is formed in the female die 65. The recessed portion 67 is recessed in accordance with the shape of the sheet-formed component 56. The depth of the recessed portion 67 is set so that only a portion of the sheet-formed component 56 up to a position between the distal end and the proximal end of the side wall 56S is inserted in the recessed portion 67. A bulging portion 68, which bulges toward the recessed portion 67, is formed in the male die 66. An injection passage 69, through which resin is injected, is formed in the male die 66. The injection passage 69 is open at a portion of the bulging portion 68. As shown in FIG 9, the sheet-formed component 56 is fitted in, and fixed to the recessed portion 67, and then, the female die 65 and the male die 66 are combined. Then, the bulging portion 68 of the male die 66 is inserted into the metallic forming sheet 10 to form a molding space (not shown) between the sheet-formed component 56 and the bulging portion 68. At this time, a parting line PL of the injection molding die 64 is located at the position between the distal end and the proximal end of the side wall 56S of the sheet-formed component 56. The molding space is also formed between the male die 66 and the distal end of the side wall 56S. After the molding space is filled with the melted resin through the injection passage 69, the injection molding die 64 is cooled. After the melted resin is solidified, the female die 65 and the male die 66 are moved away from each other. Thus, the process of forming the covered body 57 is completed, and the process of producing the metallic resin cover 55 is also completed.

The metallic resin cover 55 thus produced is fitted in the outer surface groove 51M of the handle body 51 shown in FIG. 2, and the fixation piece 55F is engaged with the handle body 51, as shown in FIG. 3. Then, the screw is fastened to the cylindrical portion 55E, and thus, the metallic resin cover 55 is fixed to the handle body 51. Thus, the metallic resin cover 55 constitutes a portion of the outer wall of the door handle 50. That is, metallic decoration is provided in a portion of the outer surface of the door handle 50.

Next, advantageous effects of the metallic resin cover 55 according to the embodiment will be described. In the metallic resin cover 55 according to the embodiment, the metal layer 13, which covers the outer surface of the covered body 57, includes the plurality of metal objects 13A as shown in FIG. 10. The metal layer 13 has the metal-object discretely arranged structure in which the metal objects 13A are away from each other. Therefore, the entire metal layer 13 is not one continuous conductive layer. Thus, when the metallic decoration is provided in a portion of the door handle 50 using the metallic resin cover 55 in which the metal layer 13 covers the outer surface of the covered body 57, it is possible to suppress an adverse effect on the capacitance sensor 53, as compared to when conventional plating or a conventional metallic forming sheet is used. Accordingly, it is possible to make the metallic decorative surface larger than a conventional metallic decorative surface, without decreasing the detection function of the capacitance sensor 53. Also, because the average gap between the metal objects 13A that constitute the metal layer 13 is 5 to 30 nm, the entire metal layer 13 looks like one continuous metal component. Further, because the metallic resin cover 55 includes the sheet-formed component 56 formed of the metallic forming sheet 10 including the metal layer 13, and the covered body 57 that is an insert-molded component formed by insert molding using the sheet-formed component 56, for example, the metallic resin cover 55 is easily mass-produced, as compared to a cover in which the metal layer 13 is vapor-deposited on the outer surface of the covered body 57.

In general, in a sheet with a multi-layer structure, such as the metallic forming sheet 10, layers are separated from each other, when the stacked layers are curved and deformed in a manner such that the layers are curled from exposed end surfaces thereof. However, according to the embodiment, because the distal end surface 56T of the side wall 56S of the sheet-formed component 56 is covered with a stepped surface 57D of the covered body 57, the layers are prevented from being separated from each other. Further, because the side wall 56S of the sheet-formed component 56 is curved to bulge outward, the side wall 56S is prevented from being curved and deformed to bulge in a direction opposite to the direction in which the side wall 56S bulges. This also prevents the layers of the sheet-formed component 56 from being separated from each other. In addition, because the parting line PL of the injection molding die 64 is disposed at the position between the proximal end and the distal end of the side wall 56 of the sheet-formed component 56, the parting line PL is offset from the distal end surface 56T of the side wall 56 of the sheet-formed component 56. This increases the degree of adhesion between the distal end surface 56T of the side wall 56S of the sheet-formed component 56 and the covered body 57. Thus, it is possible to prevent the sheet-formed component 56 from being separated from the covered body 57, in addition to preventing the layers of the sheet-formed component 56 from being separated from each other.

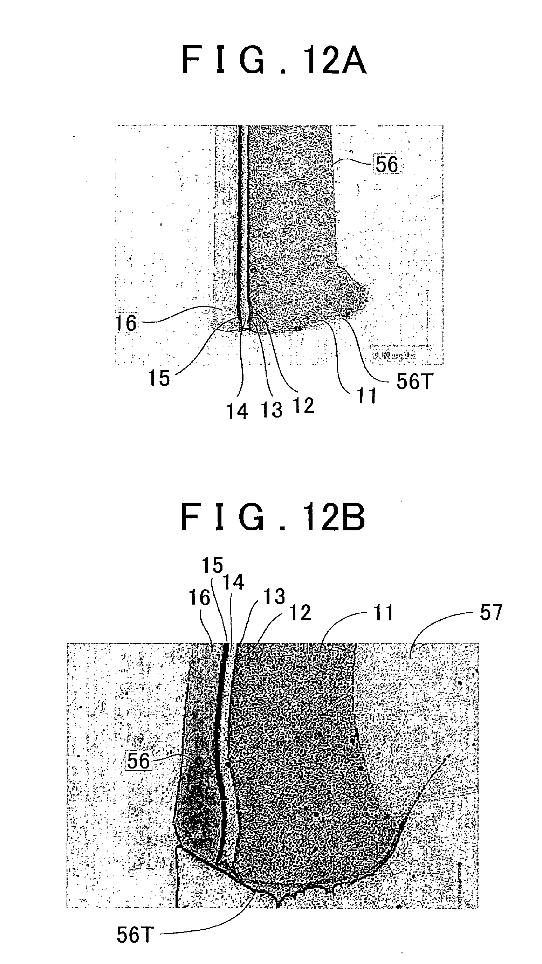

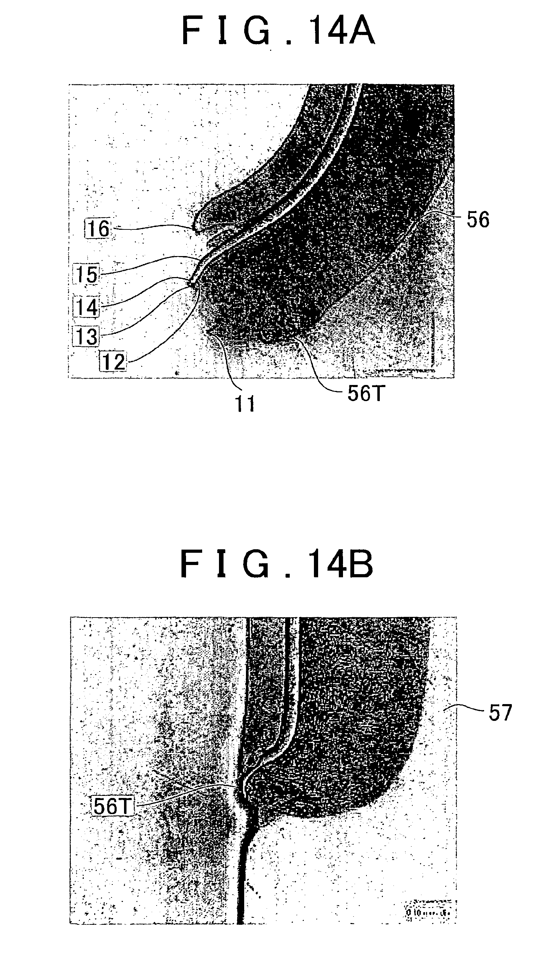

Also, in the embodiment, because the laser gun 10L is used in the trimming process in which the sheet-formed component 56 is separated from the entire metallic forming sheet 10, the cut end surface (trimmed surface) of the sheet-formed component 56 is relatively flat. More specifically, FIG. 12A shows the section of the distal end portion of the side wall 56S of the sheet-formed component 56 cut out by laser. FIG. 14A shows the section of the distal end portion of the side wall 56S of the sheet-formed component 56 cut out by a press machine, for the purpose of comparison. As shown in FIG. 14A, the layers of the sheet-formed component 56 are separated from each other at the surface formed by press-cutting, immediately after the trimming process is completed. In contrast, as shown in FIG. 12A, the layers of the sheet-formed component 56 are not separated from each other when the sheet-formed component 56 is cut out by laser. Also, when the sheet-formed component 56 is cut out by the press machine, the flat portion 10M of the metallic forming sheet 10 shown in FIG. 7 is cut. Therefore, as shown in FIG. 14B, the surface formed by press-cutting is oriented and exposed toward an area on the side of the side surface of the metallic resin cover 55. In contrast, when the sheet-formed component 56 is cut out by laser, the position and orientation of the cut surface can be set relatively freely. Therefore, the distal end surface 56T of the side wall 56S, which is the surface formed by laser cutting, can be covered with the covered body 57 (refer to FIG. 12B).

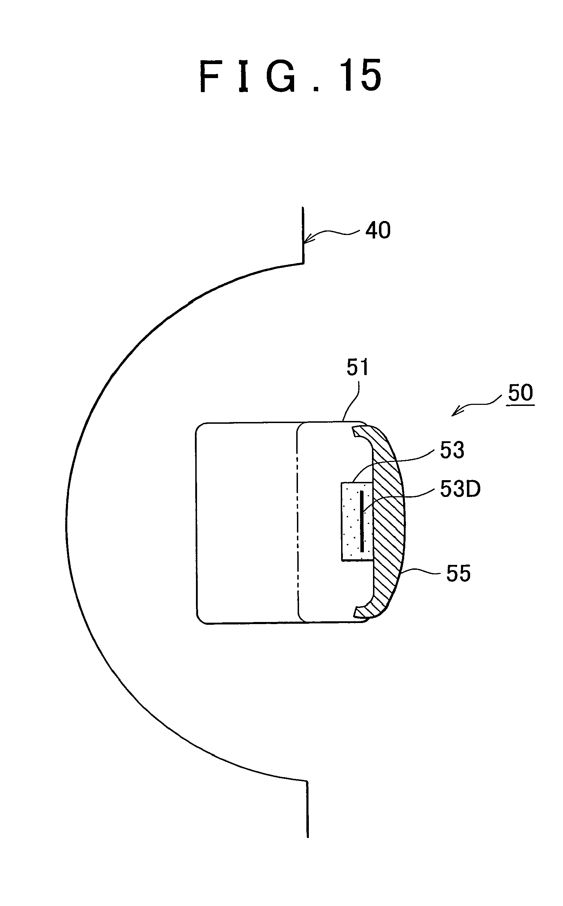

According to a second embodiment of the invention, in the inner area of the door handle 50, the capacitance sensor 53 and the detection electrode 53D thereof are disposed at positions different from positions at which the capacitance sensor 53 and the detection electrode 53D are disposed in the first embodiment. More specifically, in the second embodiment, the capacitance sensor 53 provided in the door handle 50 is in contact with a reverse side of the metallic resin cover 55, and the detection electrode 53D is disposed in the vicinity of the reverse side of the metallic resin cover 55, as shown in FIG. 15. Other portions of the configuration in the second embodiment are the same as those in the first embodiment. Therefore, the same and corresponding portions as those in the first embodiment are denoted by the same reference numerals, and the redundant description thereof will be omitted. According to the second embodiment, it is possible to obtain the same advantageous effects as those obtained in the first embodiment. In addition, it is possible to reduce thickness of the handle 50 in a direction facing the door 40, as shown by a chain line in FIG. 15.

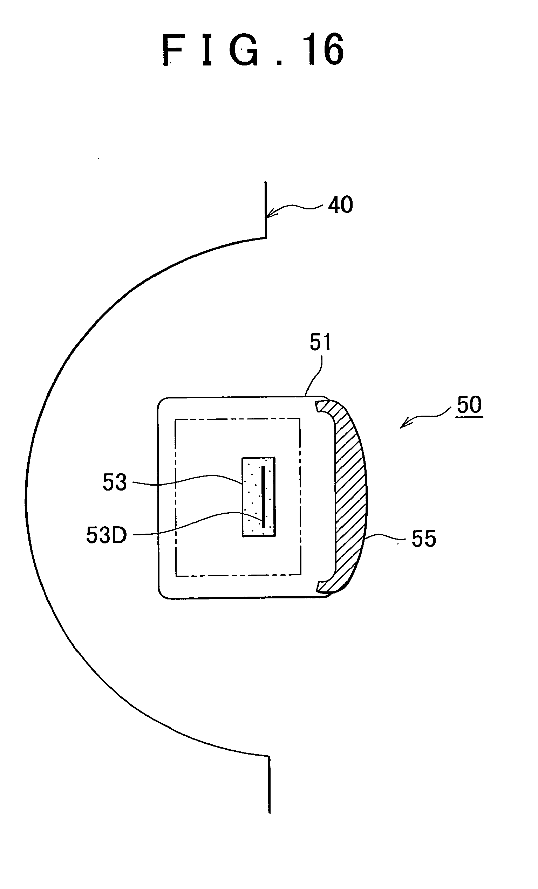

According to a third embodiment of the invention, in the inner area of the door handle 50, the capacitance sensor 53 and the detection electrode 53D thereof are disposed at positions different from the positions at which the capacitance sensor 53 and the detection electrode 53D are disposed in the first embodiment. More specifically, in the third embodiment, the detection electrode 53D of the capacitance sensor 53 is disposed in a center portion of the inner area of the door handle 50 in the direction perpendicular to the longitudinal direction of the door handle 50 as shown in FIG. 16. The center portion is far from the outer surface of the door handle 50. Other portions of the configuration in the third embodiment are the same as those in the first embodiment. Therefore, the same and corresponding portions as those in the first embodiment are denoted by the same reference numerals, and the redundant description thereof will be omitted. According to the third embodiment, it is possible to obtain the same advantageous effects as those obtained in the first embodiment. In addition, it is possible to concentrate the components of the capacitance sensor 53 including the detection electrode 53D in the center portion of the inner area of the door handle 50 in the direction perpendicular to the longitudinal direction of the door handle 50.

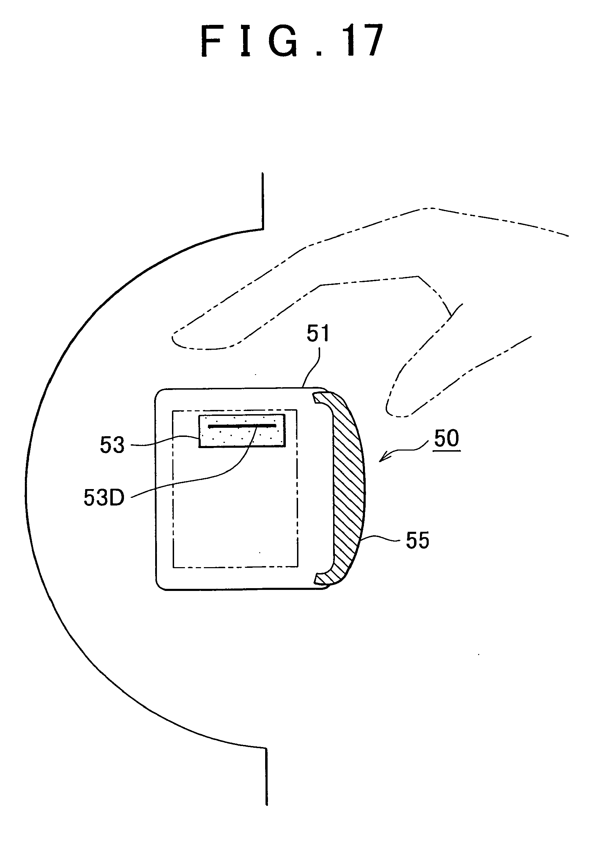

According to a fourth embodiment of the invention, in the inner area of the door handle 50, the capacitance sensor 53 and the detection electrode 53D thereof are disposed at positions different from the positions at which the capacitance sensor 53 and the detection electrode 53D are disposed in the first embodiment. More specifically, in the fourth embodiment, the detection electrode 53D of the capacitance sensor 53 is disposed in the inner area of the door handle 50 at a position closer to an upper side surface of the door handle 50 than to a lower side surface of the door handle 50, as shown in FIG. 17. Other portions of the configuration in the fourth embodiment are the same as those in the first embodiment. Therefore, the same and corresponding portions as those in the first embodiment are denoted by the same reference numerals, and the redundant description thereof will be omitted. According to the fourth embodiment, it is possible to obtain the same advantageous effects as those obtained in the first embodiment. In addition, it is possible to quickly detect that a human (a hand) touches or approaches the door handle 50 when the human is going to grasp the door handle 50 with the back of the hand facing upward.

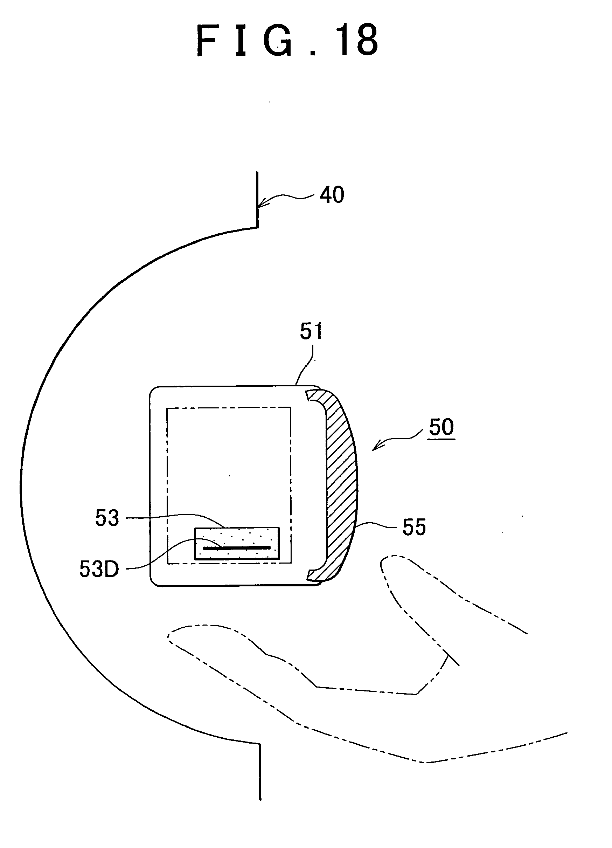

According to a fifth embodiment of the invention, in the inner area of the door handle 50, the capacitance sensor 53 and the detection electrode 53D thereof are disposed at positions different from the positions at which the capacitance sensor 53 and the detection electrode 53D are disposed in the first embodiment. More specifically, in the fifth embodiment, the detection electrode 53D of the capacitance sensor 53 is disposed in the inner area of the door handle 50 at a position closer to the lower side surface of the door handle 50 than to the upper side surface of the door handle 50, as shown in FIG. 18. Other portions of the configuration in the fifth embodiment are the same as those in the first embodiment. Therefore, the same and corresponding portions as those in the first embodiment are denoted by the same reference numerals, and the redundant description thereof will be omitted. According to the fifth embodiment, it is possible to obtain the same advantageous effects as those obtained in the first embodiment. In addition, it is possible to quickly detect that a human (a hand) touches or approaches the door handle 50 when the human is going to grasp the door handle 50 with the back of the hand facing downward. It is effective to apply the door handle 50 according to the fifth embodiment to, for example, a flip-up rear door.

The invention is not limited to the above-described embodiment. For example, embodiments described below are included in the technical scope of the invention. Further, various modifications may be made to the above-described embodiment in the scope of the invention, and the invention may be realized in embodiments other than the embodiments described below.

In the above-described embodiment, the invention is applied to the door handle 50. However, the invention may be applied to, for example, a start switch that starts an engine of the vehicle, and a touch switch for an automatic door.

In the above-described embodiment, the metal layer 13 is made of indium. However, the metal layer 13 may be made of chrome, aluminum, titanium, or tin.

In the above-described embodiment, the average thickness of the metal layer 13 is 60 nm. However, the average thickness of the metal layer 13 may be 10 to 70 nm.

In the above-described embodiments, when the capacitance sensor 53 detects that a human touches or approaches the door handle 50, the door 40 is automatically unlocked. However, the capacitance sensor 53 used for locking the door 40 may be provided, separately from the capacitance sensor 53 used for unlocking the door 40, and the detection electrodes 53D of the two capacitance sensors 53 used for unlocking/locking the door 40 may be provided in the door handle 50. When the capacitance sensor 53 used for locking the door 40 detects that a human touches or approaches the door handle 50, the door 40 is automatically locked. In this case, the door 40 is locked based on the detection that a human touches or approaches the door handle 50, in addition to unlocking the door 40 based on the detection that a human touches or approaches the door handle 50. Therefore, it is possible to make it easier to lock and unlock the door 40.

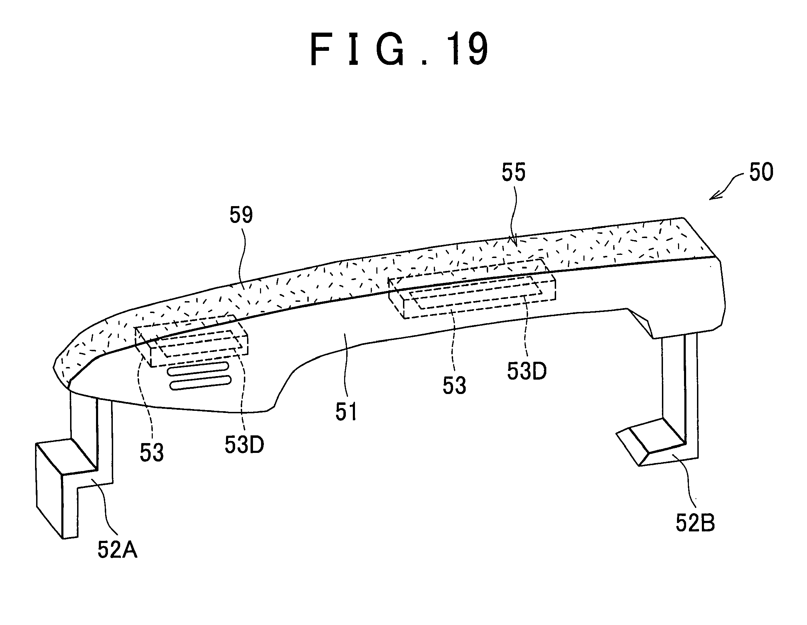

More specifically, for example, the detection electrode 53D of the capacitance sensor 53 used for unlocking the door 40 is disposed in an intermediate portion of the door handle 50 in the longitudinal direction thereof as shown in FIG. 19. The intermediate portion of the door handle 50 is grasped when the door 40 is opened. The detection electrode 53D of the capacitance sensor 53 used for locking the door 40 is disposed between the intermediate portion and one end of the door handle 50 in the longitudinal direction thereof as shown in FIG. 19. With this configuration, it is possible to avoid a situation where the two capacitance sensors 53 used for unlocking/locking the door 40 simultaneously detect that a human touches or approaches the door handle 50. Thus, it is possible to automatically unlock and lock the door 40 appropriately and smoothly. In the inner area of the door handle 50, the detection electrode 53D used for unlocking the door 40 and the detection electrode 53D used for locking the door 40 may be disposed in any one of the manners described in the first to fifth embodiments.

## Claims

1. A metallic resin cover that constitutes a portion of an outer wall of a human detection device (50) in which a detection electrode (53D) of a capacitance sensor (53) is provided, and which detects whether a human touches or approaches the human detection device (50), the metallic resin cover **characterized by** comprising:
a covered body (57); and
a metal layer (13) that has a metal-object discretely arranged structure in which a plurality of metal objects (13A) are discretely arranged, wherein the metal layer (13) covers an outer surface of the covered body (57).

2. The metallic resin cover according to claim 1, wherein
an average thickness of the metal layer (13) is 10 to 70 nm;
an average diameter of the metal objects (13A) is 30 to 150 nm when the metal layer (13) is seen in a direction of thickness of the metal layer (13); and
an average gap between the metal objects (13A) is 5 to 30 nm.

3. The metallic resin cover according to claim 2, wherein
the metal layer (13) is a metal vapor-deposited layer.

4. The metallic resin cover according to claim 3, wherein
the metal layer (13) is a layer formed by vapor-deposition of indium.

5. The metallic resin cover according to any one of claims 1 to 4, further comprising
paired resin layers (11, 14) between which the metal layer (13) is provided; wherein a sheet-formed component (56) is formed of a metallic forming sheet (10) including the paired resin layers (11, 14) and the metal layer (13) provided between the paired resin layers (11, 14); and
the covered body (57) is an insert-molded component formed by insert molding using the sheet-formed component (56).

6. The metallic resin cover according to claim 5, wherein
the sheet-formed component (56) has a groove shape or a container shape;
a side wall (56S) of the sheet-formed component (56) is curved to bulge outward;
the covered body (57) includes a stepped surface (57D) that is joined to a distal end surface (56T) of the side wall (56S) of the sheet-formed component (56).

7. An automatic locking system **characterized by** comprising:
the metallic resin cover according to any one of claims 1 to 6, wherein
the human detection device (50) is a door handle (50) for a vehicle, which is fixed to an outer wall (40P) of a door (40) of the vehicle; and
when the capacitance sensor (53) in the door handle (50) detects that a human touches or approaches the door handle (50), the door (40) is automatically unlocked or locked.

8. A method of producing a metallic resin cover, **characterized by** comprising:
forming a sheet-formed component (56) using a metallic forming sheet (10), wherein in the metallic forming sheet (10), a metal layer (13) is provided between paired first and second resin layers (11, 14), and the metal layer (13) has a metal-object discretely arranged structure in which a plurality of metal objects (13A) are discretely arranged;
forming a covered body (57) using a molding die (64) in which the sheet-formed component (56) is inserted; and
covering an outer surface of the covered body (57) with the sheet-formed component (56), wherein the covered body (57) constitutes a portion of an outer wall of a human detection device (50) in which a detection electrode (53D) of a capacitance sensor (53) is provided, and which detects whether a human touches or approaches the human detection device (50).

9. The method of producing the metallic resin cover according to claim 8, wherein
an average thickness of the metal layer (13) is 10 to 70 nm;
an average diameter of the plurality of metal objects (13A) is 30 to 150 nm when the metal layer (13) is seen in a direction of thickness of the metal layer (13); and
an average gap between the metal objects (13A) is 5 to 30 nm.

10. The method of producing the metallic resin cover according to claim 9, wherein
the metallic forming sheet (10) is formed by forming the metal layer (13) by vapor-depositing indium on a resin film (14) that is a first resin layer, and fixing a base resin film (11) that is a second resin layer, to a surface of the metal layer (13) that is opposite to a surface of the metal layer (13) that faces the first resin layer, with an adhesive layer (12) provided between the second resin layer and the metal layer (13).

11. The method of producing the metallic resin cover according to any one of claims 8 to 10, wherein
a portion of the metallic forming sheet (10) is formed into the sheet-formed component (56), and the sheet-formed component (56) is separated from the entire metallic forming sheet (10) by laser cutting.

12. The method of producing the metallic resin cover according to claim 11, wherein
the laser cutting is performed while an optical axis of the laser is inclined toward the sheet-formed component (56) by approximately 45 degrees with respect to a flat portion of the metallic forming sheet (10).

13. The method of producing the metallic resin cover according to any one of claims 8 to 12, wherein
the sheet-formed component (56) has a groove shape or a container shape, and a side wall (56S) of the sheet-formed component (56) is curved to bulge outward; and
a distal end surface (56T) of the side wall (56S) is covered with the covered body (57).

14. The method of producing the metallic resin cover according to claim 13, wherein
the covered body (57) is formed while a parting line (PL) of the molding die (64), in which the sheet-formed component (56) is inserted, is disposed at a position between a proximal end and a distal end of a side wall (56S) of the sheet-formed component (56).

15. A door handle (50) for a vehicle, which is fixed to an outer wall (40P) of a door (40) of a vehicle, and which is used in an automatic locking system in which when it is detected that a human touches or approaches the door handle (50), the door (40) is automatically unlocked or locked, the door handle (50) **characterized by** comprising:
the metallic resin cover (55) according to any one of claims 1 to 6; and
the detection electrode (53D) of the capacitance sensor (53), which detects whether the human touches or approaches the door handle (50), wherein
the metallic resin cover (55) constitutes an outer surface of the door handle (50) that is opposite to a surface of the door handle (50) that faces the door (40); and
the detection electrode (53D) is in contact with a reverse side of the metallic resin cover (55), or the detection electrode (53D) is disposed in a vicinity of the reverse side of the metallic resin cover (55).

16. A door handle (50) for a vehicle, which is fixed to an outer wall (40P) of a door (40) of a vehicle, and which is used in an automatic locking system in which when it is detected that a human touches or approaches the door handle (50), the door (40) is automatically unlocked or locked, the door handle (50) **characterized by** comprising:
the metallic resin cover (55) according to any one of claims 1 to 6; and
the detection electrode (53D) of the capacitance sensor (53), which detects whether the human touches or approaches the door handle (50), wherein
the metallic resin cover (55) constitutes an outer surface of the door handle (50) that is opposite to a surface of the door handle (50) that faces the door (40); and
the detection electrode (53D) is disposed in a center portion of an inner area of the door handle (50) in a direction perpendicular to a longitudinal direction of the door handle (50).

17. A door handle (50) for a vehicle, which is fixed to an outer wall (40P) of a door (40) of a vehicle so that the door handle (50) extends in a longitudinal direction of the vehicle, and which is used in an automatic locking system in which when it is detected that a human touches or approaches the door handle (50), the door (40) is automatically unlocked or locked, the door handle (50) **characterized by** comprising:
the metallic resin cover (55) according to any one of claims 1 to 6; and
the detection electrode (53D) of the capacitance sensor (53), which detects whether the human touches or approaches the door handle (50), wherein
the metallic resin cover (55) constitutes an outer surface of the door handle (50) that is opposite to a surface of the door handle (50) that faces the door (40); and
the detection electrode (53D) is disposed in an inner area of the door handle (50) at a position closer to an upper side surface of the door handle (50) than to a lower side surface of the door handle (50).

18. A door handle (50) for a vehicle, which is fixed to an outer wall (40P) of a door (40) of a vehicle so that the door handle (50) extends in a longitudinal direction of the vehicle, and which is used in an automatic locking system in which when it is detected that a human touches or approaches the door handle (50), the door (40) is automatically unlocked or locked, the door handle (50) **characterized by** comprising:
the metallic resin cover (55) according to any one of claims 1 to 6; and
the detection electrode (53D) of the capacitance sensor (53), which detects whether the human touches or approaches the door handle (50), wherein
the metallic resin cover (55) constitutes an outer surface of the door handle (50) that is opposite to a surface of the door handle (50) that faces the door (40); and
the detection electrode (53D) is disposed in an inner area of the door handle (50) at a position closer to a lower side surface of the door handle (50) than to an upper side surface of the door handle (50).

19. The door handle (50) according to any one of claims 15 to 18, wherein
the door handle (50) is substantially arched in a longitudinal direction thereof, and only an intermediate portion of the door handle (50) in the longitudinal direction thereof is grasped;
the metallic resin cover (55) has a band shape that extends over the entire door handle (50) in the longitudinal direction of the door handle (50), and the metallic resin cover (55) is arched;
the detection electrode (53D) of the capacitance sensor (53) used for unlocking the door (40) is disposed in the intermediate portion of the door handle (50) in the longitudinal direction thereof; and
the detection electrode (53D) of the capacitance sensor (53) used for locking the door (40) is disposed at a position between the intermediate portion and an end of the door handle (50) in the longitudinal direction thereof.
